# EUROPEAN PATENT SPECIFICATION

(11) **EP 4 286 087 B1**
(45) Date of publication and mention of the grant of the patent: **03.12.2025**
(21) Application number: 22807415.9
(22) Date of filing: 09.05.2022
(51) Int. Cl.: B23K 1/08, H05K 3/34, B23K 1/00, B23K 3/06, B23K 101/36

(54) **JET SOLDERING DEVICE**
STRAHLLÖTVORRICHTUNG
DISPOSITIF DE BRASAGE AU JET

(30) Priority: 14.05.2021 JP 2021082656
(43) Date of publication of application: 06.12.2023
(73) Proprietor: Senju Metal Industry Co., Ltd., Tokyo 120-8555 (JP)
(72) Inventor: ICHIKAWA, Hirokazu, Tokyo 120-8555 (JP); TOMITSUKA, Kenichi, Tokyo 120-8555 (JP)
(74) Representative: Hoffmann Eitle
(86) International application number: PCT/JP2022/019615
(87) International publication number: WO 2022/239713

(56) References cited:
- EP-B1- 0 292 079
- DE-A1- 4 132 582
- JP-A- H07 202 409
- JP-A- H08 309 519
- JP-A- H08 335 773
- JP-A- S5 268 050
- JP-A- S63 281 768
- JP-U- S6 316 550
- US-A- 4 540 114

## Description

### Technical Field

The present invention relates to a jet soldering apparatus that supplies molten solder to a substrate.

### Background Art

Conventionally, a jet soldering apparatus for supplying molten solder to a substrate has been known. For example, JP 2011-222785 A discloses use of an upstream jet nozzle used in a primary soldering process in which molten solder is coarsely jetted and soldered, and a downstream jet nozzle used in a secondary soldering process (for finishing) in which molten solder is finely jetted and soldered.
Further related art may be found in JP S63 281768 A which describes a jet soldering device, in EP 0 292 079 B1 which describes an apparatus for the application of conductive adhesive such as solder to a board with printed circuitry, in DE 41 32 582 A1 which describes a soldering device for flat modules and in US 4 540 114 A1 which describes an apparatus for soldering workpieces.

### SUMMARY OF INVENTION

### PROBLEM TO BE SOLVED BY INVENTION

In the case of using molten solder composed of two types of flows as in JP 2011-222785 A, it is advantageous that the solder can be cleanly attached to the substrate, but there is a tendency that an oxide of the solder is easily generated as compared with the case of using molten solder composed of one type of flow.

The present invention provides a jet soldering apparatus capable of cleanly attaching solder to a substrate and suppressing generation of an oxide of the solder and is defined by the appended independent claim. The dependent claims describe optional features and distinct embodiments.

### MEANS FOR SOLVING PROBLEM

A jet soldering apparatus according to the present invention is defined by the appended independent claim. Optional features are described in the dependent claims.

### EFFECT OF PRESENT INVENTION

In the present invention, when an aspect where when the molten solder supplied from the first supply port and the molten solder supplied from the second supply port are mixed, and the mixed molten solder is not separated from a substrate conveyed by a conveyance unit between the first supply port and the second supply port is adopted, solder can be cleanly attached to a substrate and generation of an oxide of the solder can be suppressed.

### BRIEF DESCRIPTION OF FIGURES

Fig. 1 is a schematic diagram illustrating a soldering apparatus according to a present embodiment.
Fig. 2 is an upper plan view of a jet soldering apparatus according to the present embodiment.
Fig. 3 is a side cross-sectional view illustrating one aspect of the jet soldering apparatus according to the present embodiment.
Fig. 4 is a schematic diagram illustrating an aspect in which a width of a second supply port is narrow in the jet soldering apparatus according to the present embodiment.
Fig. 5 is a schematic diagram illustrating an aspect in which the width of the second supply port is wide in the jet soldering apparatus according to the present embodiment.
Fig. 6 is a schematic diagram illustrating an aspect using one pump in the present embodiment.
Fig. 7 is an upper plan view illustrating an aspect in which two slit-shaped second openings are provided in the present embodiment.
Fig. 8 is a side cross-sectional view illustrating an aspect in which a distance between a first supply port and the second supply port is smaller than a width of an installation region of the second supply port along a substrate conveyance direction in the present embodiment.

### EMBODIMENT OF THE INVENTION

### Embodiment

### <<Configuration>>

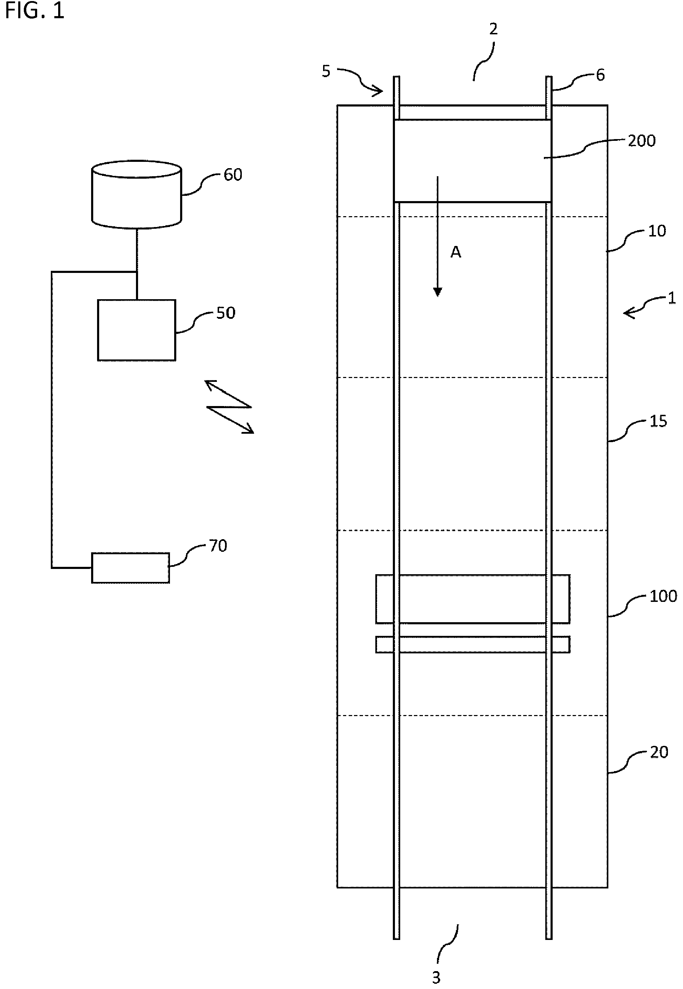

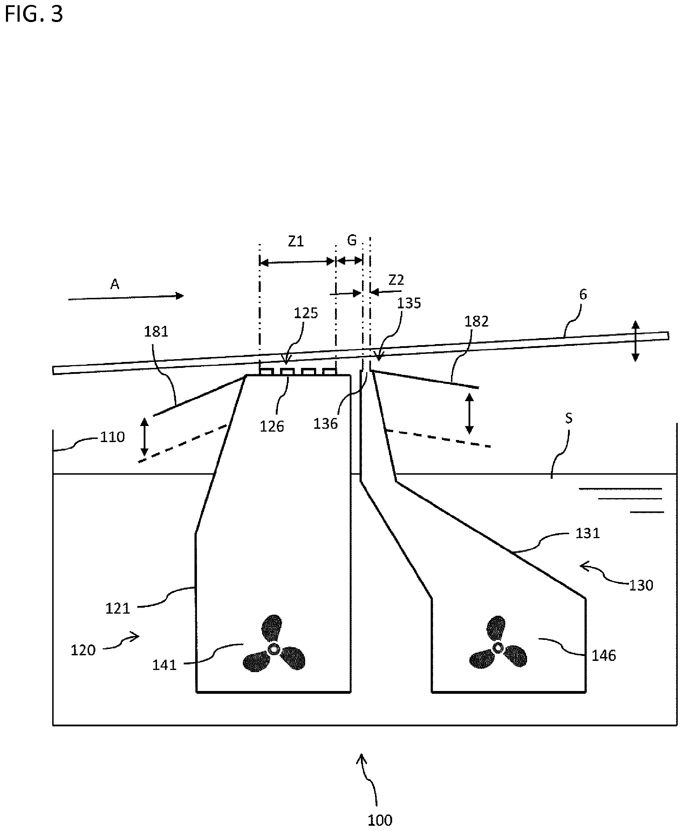

A soldering apparatus illustrated in Fig. 1 is an apparatus that performs soldering processing on a substrate 200 on which electronic components such as semiconductor elements, resistors, and capacitors are mounted on a circuit. Typically, the electronic components and the like are positioned on a lower side of the substrate 200. The soldering apparatus has a main body 1 and a conveyance unit 5 that conveys the substrate 200. The main body 1 has a carry-in port 2 through which the substrate 200 is carried in and a carry-out port 3 through which the substrate 200 is carried out. The substrate 200 may be conveyed at a predetermined angle, for example, an inclination of about 3 to 6 degrees when viewed from the side (see Fig. 3).

In this case, a downstream side is positioned at a higher position than an upstream side in a substrate conveyance direction A. However, the present invention is not limited thereto, and the substrate 200 may be horizontally conveyed, for example. The conveyance unit 5 may have a conveyance driver (not illustrated) that applies a driving force, and a conveyance rail 6 that guides the substrate 200.

As illustrated in Fig. 1, the main body 1 may be provided with a fluxer 10 for applying flux to the substrate 200, a preheater unit 15 for preheating the substrate 200 coated with flux, a jet soldering apparatus 100 for jetting molten solder into contact with the substrate 200, and a cooler 20 for cooling the soldered substrate 200. The substrate 200 conveyed along the conveyance rail 6 of the conveyance unit 5 sequentially passes through the fluxer 10, the preheater unit 15, the jet soldering apparatus 100, and the cooler 20. The jet soldering apparatus 100 may have a control unit 50 that gives a command to each component to control, and a storage unit 60 that stores various pieces of information. Note that in Fig. 1, the soldering apparatus is illustrated in an upper plan view except for the control unit 50, the storage unit 60, and an operation unit 70.

The fluxer 10 is used to apply flux to the conveyed substrate 200. The flux may include a solvent, an activator, and the like. The fluxer 10 may be provided with a plurality of coating apparatuses. The type of flux may be selectively used according to the type of solder and the type of the substrate 200.

The preheater unit 15 heats the substrate 200 to uniformly raise the substrate 200 to a predetermined temperature. When the substrate 200 is heated in this manner, the solder is easily attached to a predetermined part of the substrate 200. For example, a far-infrared panel heater is used as the preheater unit 15. The far-infrared panel heater can rapidly heat the substrate 200 to a set temperature. The substrate 200 may be heated by blowing gas (hot air) heated by the heater onto the substrate 200 by a fan. Furthermore, as the preheater unit 15, a halogen heater or the like may be used.

The cooler 20 has a cooling fan (not illustrated), and cools the substrate 200 soldered by the jet soldering apparatus 100. The control of the cooling fan may be only ON and OFF, but the wind speed may be adjusted. Furthermore, as the cooler 20, a chiller or the like may be used to cool the substrate 200 to a predetermined temperature.

The control unit 50 illustrated in Fig. 1 is communicably connected to the conveyance unit 5 including the conveyance rail 6, the fluxer 10, the preheater unit 15, the jet soldering apparatus 100, the cooler 20, the operation unit 70, and the storage unit 60. The communicable connections include both wired and wireless connections. The operation unit 70 may have a liquid crystal display panel, a numeric keypad, or the like, and is typically a personal computer, a smartphone, a tablet, or the like. When an operator operates the operation unit 70, the control unit 50 may control a conveyance speed by the conveyance unit 5, a timing of conveying the substrate 200, a temperature of the flux at the fluxer 10, an application amount of the flux, a temperature of the preheater unit 15, a temperature of molten solder S of the jet soldering apparatus 100, a jet amount, a jet speed, ON and OFF of the cooling fan of the cooler 20, and the like. The storage unit 60 may store information input by the operation unit 70, an instruction of the control unit 50, an operating time of the jet soldering apparatus 100, and the like.

Next, the jet soldering apparatus 100 of the present embodiment will be described.

As illustrated in Fig. 3, the jet soldering apparatus 100 has a storage tank 110 that stores the molten solder S, a first pump 141 that is a first drive unit, a first supply port 125 that receives a driving force from the first pump 141 and jets the molten solder S, a second pump 146 that is a second drive unit, and a second supply port 135 that receives a driving force from the second pump 146 and jets the molten solder S. The molten solder S jetted from the first supply port 125 and the second supply port 135 is jetted upward from below. The molten solder S having received the driving force from the first pump 141 is pressure-fed in a duct and jetted toward the substrate 200 to attach the solder to a predetermined part of the substrate 200. Similarly, the molten solder S having received the driving force from the second pump 146 is pressure-fed in a duct and jetted toward the substrate 200 to attach the solder to a predetermined part of the substrate 200. The molten solder S is heated to a temperature of, for example, about 180°C to 250°C by a heater (not illustrated). The molten solder supplied from the first supply port 125 and the second supply port 135 may be circulated and used. In this case, it may be circulated through a filter (not illustrated). Each of the first pump 141 and the second pump 146 is typically constituted of one pump, but each of the first pump 141 and the second pump 146 may be constituted of a plurality of pumps.

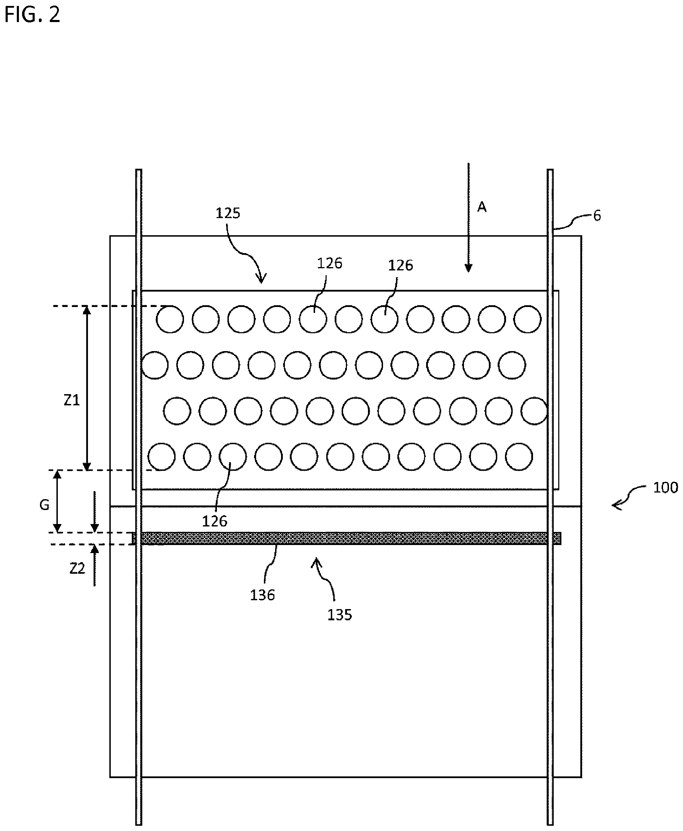

The first supply port 125 of the jet soldering apparatus 100 illustrated in Figs. 2 and 3 has a plurality of first openings 126, and the first openings 126 constitute a primary jet nozzle. The plurality of first openings 126 are used to vigorously supply a large amount of molten solder S to the substrate 200. A second opening 136 of the second supply port 135 is a secondary jet nozzle, and is used to supply the molten solder S to the substrate 200 with weaker force than the first supply port 125. The jet solder supplied from the first supply port 125 is a dynamic supply for vigorously colliding the molten solder S against the substrate 200, and is a supply for spreading the molten solder S to every corner of the substrate 200. On the other hand, the jet solder supplied from the second supply port 135 is a static supply, and is a supply for cleanly attaching the solder to an electrode or the like of the substrate 200 by passing the jet solder through the molten solder S having a gentle flow.

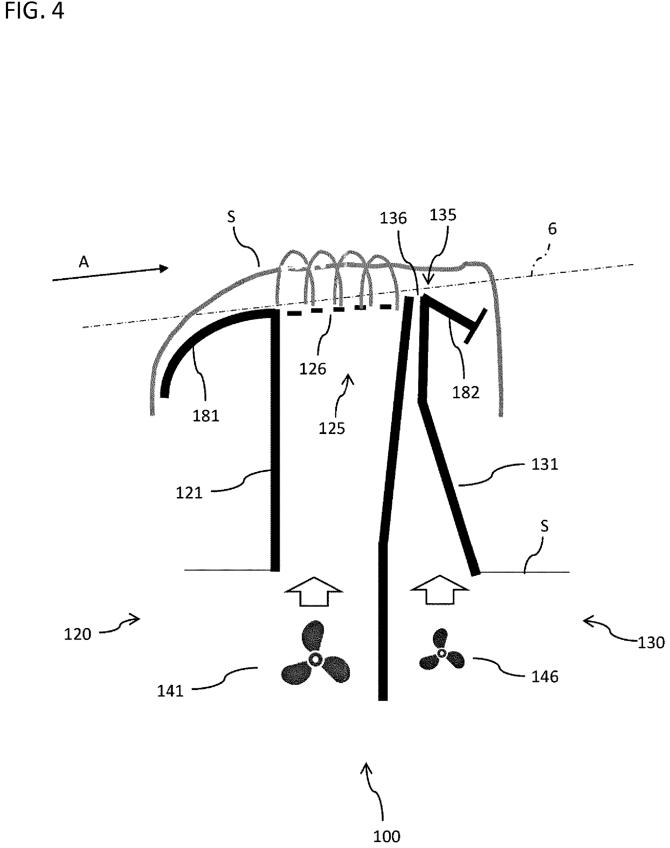

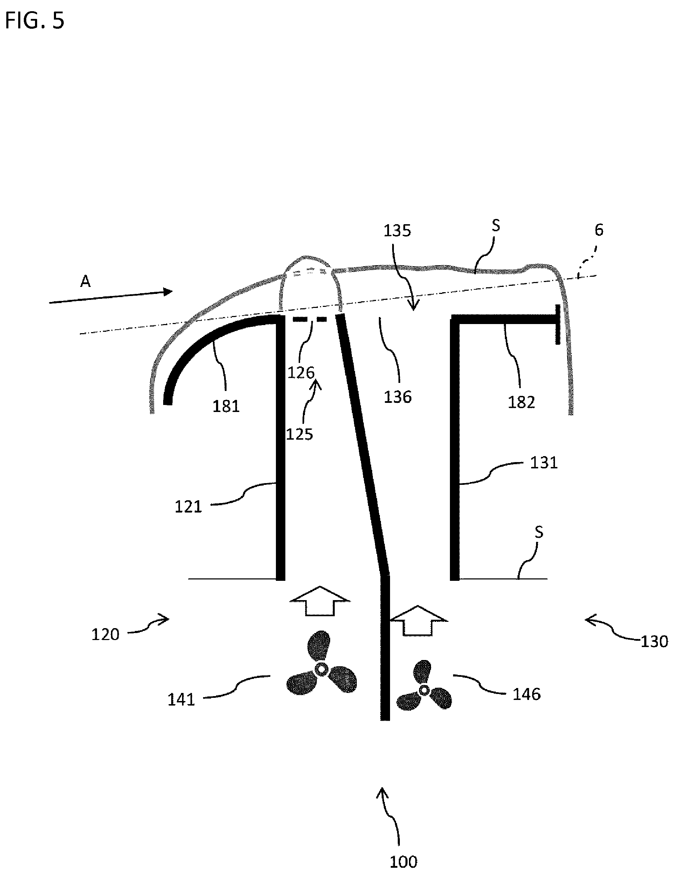

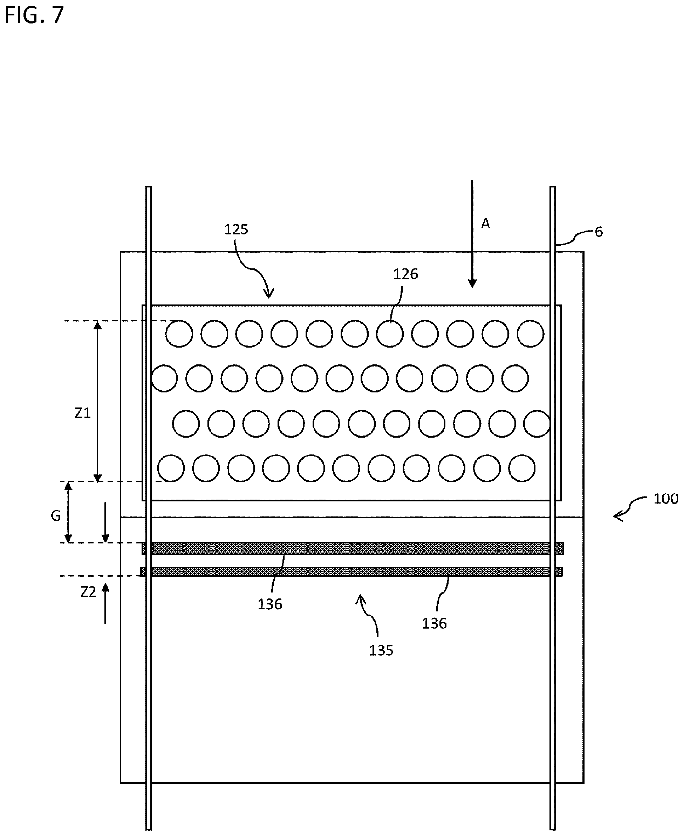

As illustrated in Fig. 3, a first supply unit 120 has a first housing 121 and the first supply port 125 provided on an upper surface of the first housing 121 and having one or the plurality of first openings 126 for supplying the molten solder S. The first opening 126 may be provided so as to protrude upward from the upper surface of the first housing 121. A second supply unit 130 has a second housing 131 and the second supply port 135 provided on an upper surface of the second housing 131 and having one or a plurality of the second openings 136 for supplying the molten solder S. The first housing 121 and the second housing 131 may be provided apart from each other (see Fig. 3), but they may be provided integrally (see Figs. 4 and 5). In a case where the first housing 121 and the second housing 131 are integrated, a part of the wall surface may be shared. In the present embodiment, the first supply port 125 having the plurality of circular first openings 126 and the second supply port 135 having one slit-shaped second opening 136 will be described as an example. However, the present invention is not limited to such an aspect, and for example, a plurality of the slit-shaped second openings 136 may be provided. In this case, the plurality of slit-shaped second openings 136 may be provided in an aspect of extending in parallel (see Fig. 7).

A temperature of the molten solder S is generally about 50°C higher than a melting temperature of the solder. In recent years, there has been an increasing need to lower a working temperature in order to reduce damage to components and reduce mechanical power consumption. Furthermore, since the market price of Sn and Ag has increased, it has been studied that a solder that does not use Sn or Ag is used, and typically, it has been studied that Sn-58Bi (melting point of 139°C) is used instead of Sn-3Ag-0.5Cu (melting point of 217°C). Sn-58Bi is a low-temperature eutectic solder. Note that, when Sn-58Bi is used, soldering can be performed at a temperature of 200°C or lower. On the other hand, since Sn-58Bi has a property of being hard and brittle, it is a material difficult to handle.

While the molten solder S is supplied, the molten solder S supplied from the first supply port 125 and the molten solder S supplied from the second supply port 135 are mixed. The molten solder mixed in this manner may not be separated from the substrate 200 conveyed by the conveyance unit 5 between the first supply port 125 and the second supply port 135 (see Figs. 4 and 5). The substrate 200 is supported and conveyed by the conveyance rail 6, but an upper surface of the mixed molten solder S may not be positioned below a lower end of the conveyance rail 6 that conveys the substrate 200 when viewed from a side in an entire length region along the substrate conveyance direction A between the first supply port 125 and the second supply port 135. In the present embodiment, "between the first supply port 125 and the second supply port 135" means between a downstream end in the substrate conveyance direction A of the first supply port 125 and an upstream end in the substrate conveyance direction A of the second supply port 135 (see "G" in Figs. 2 and 3). Note that in Figs. 4 and 5, the components other than the first pump 141 and the second pump 146 are illustrated as cross-sectional views when viewed from the side.

In the conventional aspect, a place where the molten solder S is not in contact with the substrate 200 is provided between the molten solder S supplied from the first supply port 125 and the molten solder S supplied from the second supply port 135, and the molten solder S is jetted clearly in two stages. However, in the present embodiment, the molten solder S supplied from the first supply port 125 and the molten solder S supplied from the second supply port 135 are integrated and jetted to a position higher than a conveyance position of the substrate 200.

A width Z2 of the installation region of the second supply port 135 along the substrate conveyance direction A may be smaller than a width Z1 of the installation region of the first supply port 125 along the substrate conveyance direction A. In a case where the plurality of first openings 126 are provided as in the present embodiment, a region between both ends of the plurality of first openings 126 is the width Z1 of the installation region of the first supply port 125 along the substrate conveyance direction **A.** The same applies to the second supply port 135, and in a case where the plurality of second openings 136 are provided, a region between both ends of the plurality of second openings 136 is the width Z2 of the installation region of the second supply port 135 along the substrate conveyance direction A (see Fig. 7). In the present embodiment, the "width of the installation region along the substrate conveyance direction A" coincides with the "width measured along an extending direction of the conveyance rail 6".

The width Z2 of the installation region of the second supply port 135 along the substrate conveyance direction A may be narrower than the width Z1 of the installation region of the first supply port 125 along the substrate conveyance direction A. As an example, the width Z2 of the installation region of the second supply port 135 along the substrate conveyance direction A may be 1/20 or more and 1/3 or less of the width Z1 of the installation region of the first supply port 125 along the substrate conveyance direction A (see Fig. 2). More specifically, the width Z2 of the installation region of the second supply port 135 along the substrate conveyance direction A may be 1/15 or more and 1/5 or less of the width Z1 of the installation region of the first supply port 125 along the substrate conveyance direction A.

A total amount of the molten solder S per unit time supplied from the first openings 126 which are a primary jet nozzle may be about the same as a total amount of the molten solder S per unit time supplied from the second opening 136 which is a secondary jet nozzle, or may be 0.8 times or more and 1.2 times or less. The total amount of molten solder S per unit time supplied from the first openings 126 and the total amount of molten solder S per unit time supplied from the second opening 136 which is the secondary jet nozzle may be changed according to the type of the substrate 200. When identification information of the substrate 200 is input from the operation unit 70, a supply amount of the corresponding molten solder S may be read from the storage unit 60 by the control unit 50, and the molten solder S may be supplied from the first openings 126 and the second opening 136 by being adjusted to the read supply amount. The operation unit 70 may be capable of reading code information such as a bar code, and the control unit 50 may automatically adjust the supply amount of the molten solder S to the substrate 200 by reading the code information of the substrate 200.

The molten solder S supplied from the first openings 126 which are the primary jet nozzle may be jetted to a position higher than a surface of the molten solder S supplied from the second opening 136 which is the secondary jet nozzle. A height of the molten solder S to be jetted is, for example, about 10 mm from a tip of each of the first openings 126. The molten solder S supplied from the second supply port 135 is pushed up by the molten solder S supplied from the first supply port 125. However, since the molten solder S is the same type of liquid, the molten solder S supplied from the first openings 126 and the molten solder S supplied from the second supply port 135 are mixed.

On a downstream side of the second supply port 135 in the substrate conveyance direction A, a downstream adjusting part 182 extending in a horizontal direction or descending downward toward the downstream side may be provided (see Fig. 3). A height of the downstream adjusting part 182 may be appropriately changed. An upstream adjusting part 181 extending in the horizontal direction or rising upward toward the downstream side may be provided on an upstream side of the first supply port 125 in the substrate conveyance direction A. The upstream adjusting part 181 and the downstream adjusting part 182 may be linearly inclined, or may be inclined so as to draw an arc in a longitudinal cross section (see Fig. 4). A height adjustment of the upstream adjusting part 181 and the downstream adjusting part 182 may be manually performed, or may be automatically performed in response to a command from the control unit 50. The command from the control unit 50 may be issued on the basis of the identification information of the substrate 200. Adjusting the heights of the upstream adjusting part 181 and the downstream adjusting part 182 as described above is also advantageous in that the amount of the molten solder S supplied to the substrate 200 can be adjusted.

A height position of the conveyance rail 6 may also be adjustable (see Fig. 3). In a case where such an aspect is adopted, adjusting the height position of the conveyance rail 6 in addition to or instead of controlling the driving force of the first pump 141 and the second pump 146 is also advantageous in that it is possible to realize a configuration in which the substrate 200 continues to be in contact with the molten solder S between the first supply port 125 and the second supply port 135. The height position of the conveyance rail 6 may be manually performed, or may be automatically performed in response to a command from the control unit 50. The command from the control unit 50 may be issued on the basis of the identification information of the substrate 200.

A distance G between the first supply port 125 and the second supply port 135 along the extending direction of the conveyance rail 6 (along the substrate conveyance direction A) may be smaller than the width Z1 of the installation region of the first supply port 125 along the substrate conveyance direction A.

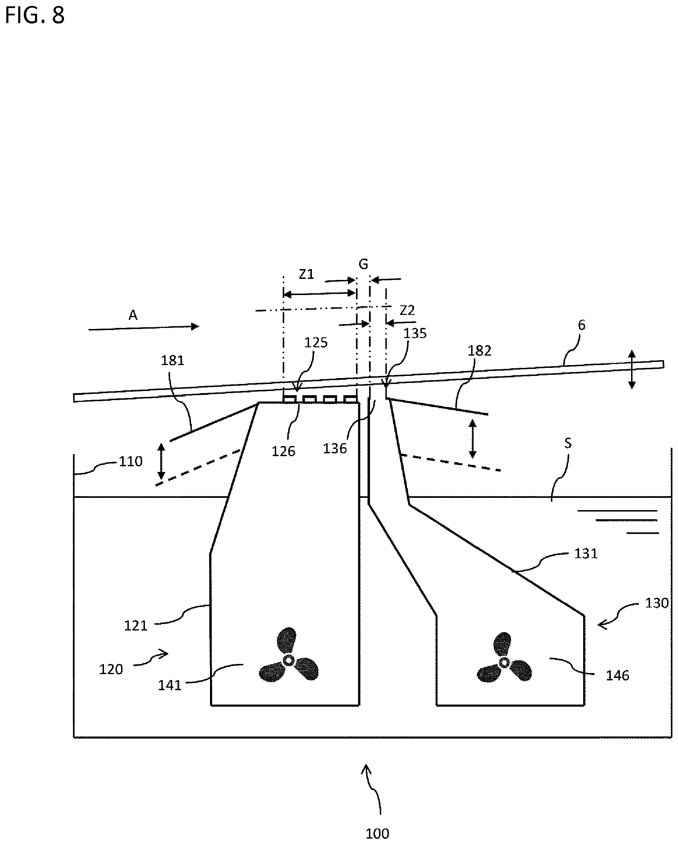

The distance G between the first supply port 125 and the second supply port 135 along the extending direction of the conveyance rail 6 extends may be smaller than the width Z2 of the installation region of the second supply port 135 along the substrate conveyance direction A (distance along the extending direction of the conveyance rail 6). In the present embodiment, as an example, it is assumed that the width Z2 of the installation region of the second supply port 135 along the substrate conveyance direction A is smaller than the width Z1 of the installation region of the first supply port 125 along the substrate conveyance direction A (see Figs. 3 and 4). Therefore, in a case where this aspect is adopted, the distance between the first supply port 125 and the second supply port 135 can be considerably close (see Fig. 8).

Next, an example of a substrate processing method will be described mainly with reference to Fig. 1.

When an operator places the substrate 200 on the conveyance rail 6, the conveyance unit 5 conveys the substrate 200, and the substrate 200 is conveyed into the main body 1 from the carry-in port 2. When the substrate 200 reaches the fluxer 10, the fluxer 10 applies flux to a predetermined part of the substrate 200.

The conveyance unit 5 conveys the substrate 200 coated with the flux by the fluxer 10 to the preheater unit 15. The preheater unit 15 heats the substrate 200 to a predetermined temperature.

Next, the conveyance unit 5 conveys the substrate 200 heated to the predetermined temperature by the preheater unit 15 to the jet soldering apparatus 100. The jet soldering apparatus 100 solders a predetermined part of the substrate 200. While the jet soldering apparatus 100 is supplying the molten solder S, the molten solder S supplied from the first supply port 125 and the molten solder S supplied from the second supply port 135 are mixed, and the molten solder S is supplied to above the conveyance rail 6. The molten solder S is configured not to be separated from the substrate 200 conveyed by the conveyance unit 5 between the first supply port 125 and the second supply port 135. Note that in a state where the substrate 200 does not exist, the molten solder S supplied from the first supply port 125 pushes up the molten solder S supplied from the second supply port 135, and a plurality of convex shapes corresponding to the first openings 126 are formed by the molten solder S.

Next, the conveyance unit 5 conveys the soldered substrate 200 to the cooler 20. For example, a cooling fan of the cooler 20 cools the soldered substrate 200 for a predetermined time. After the substrate 200 is cooled, when the conveyance unit 5 discharges the substrate 200 from the carry-out port 3, the soldering processing to the substrate 200 is completed.

### <<Effects>>

Next, effects of the present embodiment having the above-described configuration, which have not yet been described, will be mainly described. Even if it is not described in the "Configuration", any configuration described in "Effects" and covered by the scope of the appended claims can be adopted in the present invention.

According to the inventors, by adopting an aspect in which the molten solder S supplied from the first supply port 125 and the molten solder S supplied from the second supply port 135 are mixed, and the mixed molten solder S is not separated from the substrate 200 conveyed by the conveyance unit 5 between the first supply port 125 and the second supply port 135 (see Figs. 4 and 5), it has been confirmed that the molten solder S can be prevented from being oxidized (the generation of oxidized waste). By suppressing the oxidation of the molten solder S in this manner, the amount of solder that cannot be used is suppressed, so that the material cost can be reduced.

As in the related art, when molten solder S supplied from the first supply port and molten solder S supplied from the second supply port fall toward molten solder S stored separately, the molten solder S comes into contact with a large amount of oxygen at that time. Therefore, it is presumed that the generation of oxides increases.

Note that, since the specific gravity of the oxidized waste (dross) is light, the oxidized waste floats on an upper surface of the molten solder S. However, by adopting the present embodiment, the generation of such oxidized waste can be suppressed. In particular, in the case of using Sn-58Bi, the generation of the oxidized waste was considerably increased as compared with the case of using SAC305. Therefore, the aspect of the present embodiment is particularly advantageous when Sn-58Bi is used. In a case where the oxidized waste floats and accumulates on the molten solder S, it is necessary to stop the apparatus and remove the oxidized waste. However, in the case where the above aspect is adopted, the number of such operations can be reduced, and therefore the operation time of the machine can be secured, and the yield can be increased.

Furthermore, according to the above aspect, since the solder is supplied by mixing both the molten solder S supplied from the first supply port 125 and the molten solder S supplied from the second supply port 135, it is advantageous in that the total amount of the jetted molten solder S can be reduced as compared with the conventional aspect. By reducing the total amount of the molten solder S jetted in this way, the generation of the oxide described above can be suppressed. Furthermore, it is also advantageous in that the molten solder S can be supplied with a stable wave.

As illustrated in Fig. 3 and the like, in the case where the width Z2 of the installation region of the second supply port 135 along the substrate conveyance direction A is smaller than the width Z1 of the installation region of the first supply port 125 along the substrate conveyance direction A, the amount of molten solder S supplied from the second supply port 135 can be made smaller than the amount of molten solder S supplied from the first supply port 125. As a result, a plurality of waves (convex shapes) of the molten solder S supplied from the first supply port 125 can be prevented from being crushed by the molten solder S supplied from the second supply port 135, and both dynamic supply of the molten solder S from the first supply port 125 and static supply of the molten solder S from the second supply port 135 can be provided in a balanced manner. Note that, as illustrated in Fig. 5, in a case where the width Z2 of the installation region of the second supply port 135 along the substrate conveyance direction A is large, it is necessary to adjust the amount of the molten solder S to be supplied so as not to be excessively large, and at the same time, adjust the substrate 200 so as to keep in contact with the molten solder S between the second supply port 135 and the first supply port 125, which makes it difficult to adjust. From this viewpoint, it is advantageous to adopt an aspect in which the width Z2 of the installation region of the second supply port 135 along the substrate conveyance direction A is smaller than the width Z1 of the installation region of the first supply port 125 along the substrate conveyance direction A.

In order to realize such balanced supply, it is beneficial that the width Z2 of the installation region of the second supply port 135 along the substrate conveyance direction A is 1/3 or less of the width Z1 of the installation region of the first supply port 125 along the substrate conveyance direction A, and more specifically, it is beneficial that the width Z2 is 1/5 or less. Note that, in order to make the amount of the molten solder S supplied from the second supply port 135 larger than or equal to a certain amount, the width Z2 of the installation region of the second supply port 135 along the substrate conveyance direction A may be 1/20 or more of the width Z1 of the installation region of the first supply port 125 along the substrate conveyance direction A, and more specifically, may be 1/15 or more.

In the conventional aspect, the amount of the molten solder S supplied from the second supply port 135 is considerably large, and the amount of the molten solder S supplied from the second supply port 135 is nearly 1.5 to 2 times the amount of the molten solder S supplied from the first supply port 125. However, by adopting this aspect, the amount of the molten solder S supplied from the second supply port 135 can be considerably reduced. As described above, in order to prevent the plurality of waves (convex shapes) of the molten solder S supplied from the first supply port 125 from being crushed by the molten solder S supplied from the second supply port 135, the amount of the molten solder S supplied from the first supply port 125 and the amount of the molten solder S supplied from the second supply port 135 may be almost equal to each other. As an example, the amount of the molten solder S supplied from the first supply port 125 may be 0.8 times or more and 1.2 times or less the amount of the molten solder S supplied from the second supply port 135.

An aspect may be adopted in which no opening or gap through which the molten solder S falls downward is provided between the first supply port 125 and the second supply port 135 on the upper surfaces of the first housing 121 and the second housing 131 along the substrate conveyance direction A. In a case where an opening or a gap through which the molten solder S falls downward is provided, a surface area where the molten solder S comes into contact with oxygen increases, and an oxide is generated. On the other hand, in the case of adopting an aspect in which a place where the molten solder S falls, such as an opening or a gap, is not provided between the first supply port 125 and the second supply port 135 along the substrate conveyance direction A as in the present aspect, the molten solder S does not fall between the first supply port 125 and the second supply port 135 along the substrate conveyance direction A, so that generation of an oxide of the molten solder S can be prevented.

As illustrated in Figs. 2 to 4, when adopting the aspect in which the distance G between the first supply port 125 and the second supply port 135 along the substrate conveyance direction A is smaller than the width Z1 of the installation region of the first supply port 125 along the substrate conveyance direction A, the distance between the first supply port 125 and the second supply port 135 can be shortened. Therefore, it is advantageous in that it is possible to realize an aspect in which the molten solder S is not separated from the substrate 200 conveyed by the conveyance unit 5 between the first supply port 125 and the second supply port 135 while reducing the amount of the molten solder S supplied from the second supply port 135.

In the aspect in which the width Z2 of the installation region along the substrate conveyance direction A of the second supply port 135 is smaller than the width Z1 of the installation region along the substrate conveyance direction A of the first supply port 125, when adopting an aspect in which the distance G between the first supply port 125 and the second supply port 135 is smaller than the width Z2 of the installation region along the substrate conveyance direction A of the second supply port 135 (see Fig. 8), the distance between the first supply port 125 and the second supply port 135 can be further shortened. Therefore, it is advantageous in that it is possible to realize an aspect in which the molten solder S is not separated from the substrate 200 conveyed by the conveyance unit 5 between the first supply port 125 and the second supply port 135 while further reducing the amount of the molten solder S supplied from the second supply port 135.

### (Modified example)

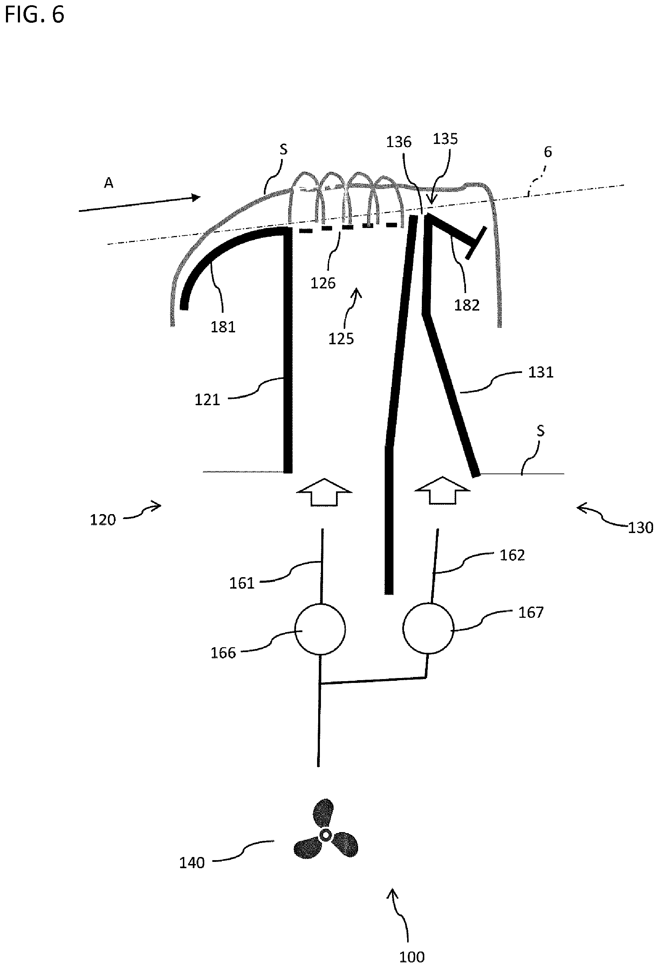

The amount of the molten solder S supplied from the first supply port 125 and the amount of the molten solder S supplied from the second supply port 135 may be adjustable. As an example, as illustrated in Fig. 6, one pump 140 may be provided, and the amount of molten solder S flowing into a first passage 161 connected to the first supply port 125 and the amount of molten solder S flowing into a second passage 162 connected to the second supply port 135 may be adjustable. The amount of the molten solder S flowing into the first passage 161 may be adjusted by a first adjustment valve 166, and the amount of the molten solder S flowing into the second passage 162 may be adjusted by a second adjustment valve 167. The amount of the molten solder S flowing into the first passage 161 and the amount of the molten solder S flowing into the second passage 162 may be adjusted by a relative ratio between an opening degree of the first adjustment valve 166 and an opening degree of the second adjustment valve 167. In a case where this aspect is adopted, the amount of the molten solder S supplied from the first supply port 125 and the amount of the molten solder S supplied from the second supply port 135 can be adjusted while using only one pump 140. The opening degrees of the first adjustment valve 166 and the second adjustment valve 167 may be automatically adjusted in response to a command from the control unit 50 based on the information read from the storage unit 60 on the basis of the identification information of the substrate input by the operation unit 70 or read by the operation unit 70.

However, since it is difficult to adjust the amount of the molten solder S using only one pump 140 to a certain extent, in the general jet soldering apparatus 100 in which many types of substrates 200 have to be treated in one day, it is advantageous that the amount of the molten solder S supplied from the first supply port 125 and the second supply port 135 can be adjusted using two or more pumps as described above.

As another aspect, sizes of the inlets of the first passage 161 and the second passage 162 may be appropriately adjusted while using only one pump 140. In this case, by manually or automatically adjusting the sizes of the inlets of the first passage 161 and the second passage 162, the amount of the molten solder S supplied from the first supply port 125 and the amount of the molten solder S supplied from the second supply port 135 can be adjusted.

Note that a plurality of the pumps 140 may also be provided in the modified example. Also in this case, the amount of the molten solder S supplied from the first supply port 125 and the amount of the molten solder S supplied from the second supply port 135 may be adjustable by adjusting the opening degrees of the first adjustment valve 166 and the second adjustment valve 167 and the sizes of the inlets of the first passage 161 and the second passage 162.

The above description of each embodiment and the disclosure of the drawings are merely examples for describing the present invention, the scope of which is defined by the appended claims.

### REFERENCE SIGNS LIST

- 5: conveyance unit
- 100: jet soldering apparatus
- 121: first housing
- 125: first supply port
- 131: second housing
- 135: second supply port
- 141: first pump (first drive unit)
- 146: second pump (second drive unit)
- 200: substrate
- A: substrate conveyance direction
- G: distance between first supply port and second supply port
- S: molten solder
- Z1: width of installation region of first supply port along substrate conveyance direction
- Z2: width of installation region of second supply port along substrate conveyance direction

## Claims

1. A soldering apparatus, comprising:
a main body (1), which comprises:
a fluxer (10),
a preheater unit (15),
a jet soldering apparatus (100),
a cooler (20), and
a conveyance unit (5) with a conveyance rail (6) for sequentially passing a substrate (200) through the fluxer, the preheater unit, the jet soldering apparatus (100), and the cooler along a substrate conveyance direction (A),
wherein the jet soldering apparatus (100), in which solder is to be jetted towards the substrate, comprises:
a first housing (121);
a first supply port (125) provided on the first housing, configured to provide molten solder and having a plurality of circular first openings (125);
a second housing (131); and
a second supply port (135) provided on the second housing, configured to provide the molten solder and having one or a plurality of slit-shaped second openings (136),
wherein the molten solder when supplied from the first supply port and the molten solder when supplied from the second supply port are mixed, and the mixed molten solder is not separated from the substrate to be conveyed by the conveyance unit between the first supply port and the second supply port,
wherein an upper surface of the mixed molten solder is not positioned below a lower end of the conveyance rail that conveys the substrate in an entire length region along the substrate conveyance direction between the first supply port and the second supply port,
wherein an opening or gap where the molten solder falls is not provided between the first supply port and the second supply port along the substrate conveyance direction, and
wherein a width Z2 of an installation region of the second supply port along the substrate conveyance direction is smaller than a width Z1 of an installation region of the first supply port along the substrate conveyance direction, and a region between both ends of the plurality of the first openings is the width Z1 and a region between both ends of the second opening or the plurality of second openings is the width Z2, and
the solder apparatus being **characterized in that**
a distance G between the first supply port and the second supply port along the substrate conveyance direction (A) is smaller than the width Z2 of the installation region of the second supply port along the substrate conveyance direction.

2. The soldering apparatus according to claim 1,
wherein the jet soldering apparatus further comprises:
a first drive unit (141) giving a driving force to the molten solder provided from the first supply port; and
a second drive unit (146) giving a driving force to the molten solder provided from the second supply port.

3. The soldering apparatus according to claim 1 or 2,
wherein the width of the installation region of the second supply port along the substrate conveyance direction is 1/3 or less of the width of the installation region of the first supply port along the substrate conveyance direction.

4. The soldering apparatus according to any one of the preceding claims further comprising a control unit (50),
wherein the control unit is configured to set an amount of the molten solder supplied from the first supply port to 0.8 times or more and 1.2 times or less of an amount of the molten solder supplied from the second supply port.

## Patentansprüche

1. Löteinrichtung, umfassend:
einen Hauptkörper (1), der Folgendes umfasst:
eine Flussmittelauftragseinheit (10),
eine Vorheizeinheit (15),
eine Strahllöteinrichtung (100),
eine Kühleinheit (20) und
eine Fördereinrichtung (5) mit einer Führungsschiene (6), um ein Substrat (200) nacheinander durch die Flussmittelauftragseinheit, die Vorheizeinheit, die Strahllöteinrichtung (100) und die Kühleinheit in Substrat-Förderrichtung (A) zu führen,
wobei die Strahllöteinrichtung (100), in der Lot in Richtung auf das Substrat gestrahlt werden soll, Folgendes umfasst:
ein erstes Gehäuse (121);
einen ersten Auslass (125), der an dem ersten Gehäuse bereitgestellt ist, dazu ausgebildet ist, geschmolzenes Lot bereitzustellen, und eine Vielzahl kreisförmiger erster Düsenöffnungen (125) aufweist;
ein zweites Gehäuse (131); und
einen zweiten Auslass (135), der an dem zweiten Gehäuse bereitgestellt ist, dazu ausgebildet ist, das geschmolzene Lot bereitzustellen, und eine oder mehrere schlitzförmige zweite Düsenöffnungen (136) aufweist,
wobei sich das geschmolzene Lot, wenn es aus dem ersten Auslass ausgebracht wird, und das geschmolzene Lot, wenn es aus dem zweiten Auslass ausgebracht wird, mischen und das gemischte geschmolzene Lot zwischen dem ersten Auslass und dem zweiten Auslass nicht von dem durch die Fördereinrichtung zu fördernden Substrat getrennt wird,
wobei eine Oberseite des gemischten geschmolzenen Lots in einem gesamten Längenbereich entlang der Substrat-Förderrichtung zwischen dem ersten Auslass und dem zweiten Auslass nicht unterhalb eines unteren Endes der das Substrat fördernden Führungsschiene positioniert ist,
wobei zwischen dem ersten Auslass und dem zweiten Auslass entlang der Substrat-Förderrichtung keine Öffnung oder kein Spalt bereitgestellt ist, an dem das geschmolzene Lot herabfällt, und
wobei eine Breite Z2 eines Anordnungsbereichs des zweiten Auslasses entlang der Substrat-Förderrichtung kleiner ist als eine Breite Z1 eines Anordnungsbereichs des ersten Auslasses entlang der Substrat-Förderrichtung, und ein Bereich zwischen beiden Enden der Vielzahl der ersten Düsenöffnungen die Breite Z1 ist und ein Bereich zwischen beiden Enden der zweiten Düsenöffnung oder der Vielzahl der zweiten Düsenöffnungen die Breite Z2 ist, und
**dadurch gekennzeichnet, dass**
ein Abstand G zwischen dem ersten Auslass und dem zweiten Auslass entlang der Substrat-Förderrichtung (A) kleiner ist als die Breite Z2 des Anordnungsbereichs des zweiten Auslasses entlang der Substrat-Förderrichtung.

2. Löteinrichtung nach Anspruch 1,
wobei die Strahllöteinrichtung weiter Folgendes umfasst:
eine erste Antriebseinheit (141), die dem aus dem ersten Auslass bereitgestellten geschmolzenen Lot eine Antriebskraft verleiht; und
eine zweite Antriebseinheit (146), die dem aus dem zweiten Auslass bereitgestellten geschmolzenen Lot eine Antriebskraft verleiht.

3. Löteinrichtung nach Anspruch 1 oder 2,
wobei die Breite des Anordnungsbereichs des zweiten Auslasses entlang der Substrat-Förderrichtung 1/3 oder weniger der Breite des Anordnungsbereichs des ersten Auslasses entlang der Substrat-Förderrichtung beträgt.

4. Löteinrichtung nach einem der vorstehenden Ansprüche, weiter umfassend eine Steuereinheit (50),
wobei die Steuereinheit dazu konfiguriert ist, eine Menge des aus dem ersten Auslass bereitgestellten geschmolzenen Lots auf mindestens das 0,8-Fache und höchstens das 1,2-Fache einer Menge des aus dem zweiten Auslass bereitgestellten geschmolzenen Lots festzulegen.

## Revendications

1. Appareil de brasage, comprenant :
un corps principal (1), qui comprend :
une unité de fluxage (10),
une unité de préchauffage (15),
un appareil de brasage au jet (100),
un refroidisseur (20), et
une unité de convoyage (5) munie d'un rail de convoyage (6) pour faire passer séquentiellement un substrat (200) à travers l'unité de fluxage, l'unité de préchauffage, l'appareil de brasage au jet (100) et le refroidisseur le long d'une direction (A) de convoyage du substrat,
dans lequel l'appareil de brasage au jet (100), dans lequel de la brasure doit être projetée vers le substrat, comprenant :
un premier boîtier (121) ;
un premier orifice d'alimentation (125) prévu sur le premier boîtier, configuré pour fournir de la brasure en fusion et présentant une pluralité de premières ouvertures circulaires (125) ;
un deuxième boîtier (131) ; et
un deuxième orifice d'alimentation (135) prévu sur le deuxième boîtier, configuré pour fournir la brasure en fusion et présentant une ou une pluralité de deuxièmes ouvertures en forme de fente (136),
dans lequel la brasure en fusion lorsqu'elle est fournie par le premier orifice d'alimentation et la brasure en fusion lorsqu'elle est fournie par le deuxième orifice d'alimentation sont mélangées, et la brasure en fusion mélangée n'est pas séparée du substrat devant être convoyé par l'unité de convoyage entre le premier orifice d'alimentation et le deuxième orifice d'alimentation,
dans lequel une surface supérieure de la brasure en fusion mélangée n'est pas positionnée en dessous d'une extrémité inférieure du rail de convoyage qui convoie le substrat dans une région de longueur entière le long de la direction de convoyage du substrat entre le premier orifice d'alimentation et le deuxième orifice d'alimentation,
dans lequel une ouverture ou un espace par lequel la brasure en fusion tombe n'est pas prévu entre le premier orifice d'alimentation et le deuxième orifice d'alimentation le long de la direction de convoyage du substrat, et
dans lequel une largeur Z2 d'une région d'installation du deuxième orifice d'alimentation le long de la direction de convoyage du substrat est inférieure à une largeur Z1 d'une région d'installation du premier orifice d'alimentation le long de la direction de convoyage du substrat, et une région entre les deux extrémités de la pluralité des premières ouvertures est la largeur Z1 et une région entre les deux extrémités de la deuxième ouverture ou de la pluralité de deuxièmes ouvertures est la largeur Z2, et
l'appareil de brasage étant **caractérisé en ce que**
une distance G entre le premier orifice d'alimentation et le deuxième orifice d'alimentation le long de la direction (A) de convoyage du substrat est inférieure à la largeur Z2 de la région d'installation du deuxième orifice d'alimentation le long de la direction de convoyage du substrat.

2. Appareil de brasage selon la revendication 1,
dans lequel l'appareil de brasage au jet comprend en outre :
une première unité d'entraînement (141) donnant une force d'entraînement à la brasure en fusion fournie depuis le premier orifice d'alimentation ; et
une deuxième unité d'entraînement (146) donnant une force d'entraînement à la brasure en fusion fournie depuis le deuxième orifice d'alimentation.

3. Appareil de brasage selon la revendication 1 ou la revendication 2,
dans lequel la largeur de la région d'installation du deuxième orifice d'alimentation le long de la direction de convoyage du substrat est égale ou inférieure à 1/3 de la largeur de la région d'installation du premier orifice d'alimentation le long de la direction de convoyage du substrat.

4. Appareil de brasage selon l'une quelconque des revendications précédentes, comprenant en outre une unité de commande (50),
dans lequel l'unité de commande est configurée pour régler une quantité de la brasure en fusion fournie depuis le premier orifice d'alimentation à une valeur égale ou supérieure à 0,8 fois et égale ou inférieure à 1,2 fois une quantité de la brasure en fusion fournie depuis le deuxième orifice d'alimentation.
